(19)

Europäisches
Patentamt
European
Patent Office
Office européen
des brevets

(11)  **EP 1 558 992 B1**

(12)  **EUROPEAN PATENT SPECIFICATION**

(45) Date of publication and mention
of the grant of the patent:
**09.09.2015  Bulletin 2015/37**

(51) Int Cl.:
***H03H 17/02*** *(2006.01)*

(21) Application number: **02787584.8**

(22) Date of filing: **06.11.2002**

(86) International application number:
**PCT/EP2002/012409**

(87) International publication number:
**WO 2004/042553 (21.05.2004 Gazette 2004/21)**

(54) **METHOD, SYSTEM AND COMPUTER PROGRAM FOR DIGITAL SIGNAL PROCESSING**

VERFAHREN, SYSTEM UND COMPUTERPROGRAMM ZUR DIGITALEN SIGNALVERARBEITUNG

PROCEDE, SYSTEME ET PROGRAMME INFORMATIQUE POUR LE TRAITEMENT DE SIGNAUX
NUMERIQUES

(84) Designated Contracting States:
**DE ES FR GB IT SE**

(43) Date of publication of application:
**03.08.2005  Bulletin 2005/31**

(73) Proprietor: **Nira Dynamics AB
583 30 Linköping (SE)**

(72) Inventors:
 • **GUSTAVSSON, Tony
 43639 Askim (SE)**
 • **PERSSON, Niclas
 S-582 38 Linköping (SE)**
 • **GUSTAVSSON, Fredrik
 S-590 71 Ljungsbro (SE)**

(74) Representative: **Samson & Partner Patentanwälte
mbB
Widenmayerstraße 6
80538 München (DE)**

(56) References cited:
 **WO-A-01/87647   US-A- 4 494 214**

 • **PERSSON N ET AL: "Event based sampling with
 application to vibration analysis in pneumatic
 tires" 2001 IEEE INTERNATIONAL CONFERENCE
 ON ACOUSTICS, SPEECH, AND SIGNAL
 PROCESSING. PROCEEDINGS (CAT. NO.
 01CH37221), 2001 IEEE INTERNATIONAL
 CONFERENCE ON ACOUSTICS, SPEECH, AND
 SIGNAL PROCESSING. PROCEEDINGS, SALT
 LAKE CITY, UT, USA, 7-11 MAY 2001, pages
 3885-3888 vol.6, XP002247684 2001, Piscataway,
 NJ, USA, IEEE, USA ISBN: 0-7803-7041-4**
 • **CALVAGNO G.; MUNSON D.C. JR: "A frequency-
 domain approach to interpolation from a
 nonuniform grid", SIGNAL PROCESSING, vol. 52,
 no. 1, 1 July 1996 (1996-07-01), pages 1-21,
 XP004008754, ELSEVIER SCIENCE
 PUBLISHERS B.V. AMSTERDAM, NL**
 • **HUFF W.; GALTON I.: "Nonuniform-to-uniform
 decimation for delta-sigma frequency-to-digital
 conversion", CIRCUITS AND SYSTEMS, 1998.
 ISCAS '98. PROCEEDINGS OF THE 1998 IEEE
 INTERNATIONAL SYMPOSIUM ON MONTEREY,
 vol. 1, 31 May 1998 (1998-05-31), pages 365-368,
 XP010289628, NEW YORK, NY, USA, IEEE, US**

**Description**

FIELD OF THE INVENTION

The invention relates in general to the field of digital signal processing and more particular to methods, a system and a computer program for processing a discretized input signal provided in form of a plurality of discrete input signal values at corresponding discrete input time instants which are distributed non-equidistantly in time.

BACKGROUND OF THE INVENTION

Digital signal processing (DSP) is the processing of signals by digital means. Historically the origins of signal processing are in electrical engineering, and a signal here means an electrical signal carried by a wire or telephone line, or by a radio wave. Following the development of signal processing, a signal nowadays is in general considered a stream of information, for example stock prices, data from a remote-sensing satellite, etc. (for a general introduction to signal processing see the book: Introduction to Signal Processing, S. J. Orfanidis, Prentice Hall 1995).

In many cases, the signal is initially in the form of an analog electrical voltage or current, produced for example by a transducer. An analog signal must be converted into digital (i.e. numerical) form before DSP techniques can be applied. The conversion generates a discretized signal in the form of binary numbers.

In DSP discretized signals are commonly processed in a variety of ways, for example by using a filter circuit in order to remove or at least reduce the unwanted part of the signal. DSP is often implemented in Digital Signal Processor chips - specialized microprocessors with architectures designed specifically for the types of operations required in DSP. DSP technology is nowadays commonplace in such devices as mobile phones, multimedia computers, video recorders, CD players and automobiles.

DSP techniques often comprise Fast Fourier Transforms (FFT), which allow the frequency spectrum of a signal to be rapidly computed. A variety of signal processing methods, software products and microprocessor devices applying such a FFT require equidistantly-sampled input signals. Classical sampling techniques measure the amplitude of a continuous time signal at regular time intervals. In some special applications, the amplitudes of a continuous time signal are however not obtained equidistantly distributed in time. In this case, called event domain sampling, such standard techniques (e.g. FFT, etc.) are not applicable.

In WO 01/87647 A1 which shows the preamble of the claimed subject-matter, such an event domain sampling is disclosed in the context of measuring and analyzing the angular velocity of wheel axles in order to derive an automobile's tire pressure. To be able to apply classical signal processing tools, the document teaches to convert the event domain sampled signal (in form of discrete input signal values at corresponding discrete input time instants which are distributed non-equidistantly in time) to a time domain sampled output signal (in form of discrete output signal values at corresponding discrete output time instants which are distributed equidistantly in time, i.e. with a constant sampling period). This conversion applies nearest neighbor linear interpolation. Furthermore, this document discloses a preprocessing of the measuring signal in order to remove signal noise originating from sensor errors.

US Patent 4,494,214 describes an adaptive finite impulse response (FIR) filter used for sampled signal data. This known FIR-filter consist of a tapped delay line with weighting coefficients coupled to the taps and means for summing these. Delays between the taps are at integral multiples of the sample periods of the signal to be filtered.

Further US 4,494,214 shows a method to scale the frequency response of the filter linearly by a real factor a in time and amplitude, i.e. changing the frequency shaping of an filter output signal. The scaling is made by mathematically extrapolating the scaled coefficients by a piecewise linear calculation using the known coefficient values of an unscaled filter.

HUFF et al. ("Non-uniform-to-uniform decimation for Delta-Sigma Frequency-to-Digital Conversion", Huff W. et al., Circuits and Systems, 1998-05-31, XP010289628, ISCAS '98 Proceedings of the 1998 IEEE, International Symposium on Monterey, CA, USA 31 May - 3 June 1998, New York, NY, USA, IEEE, US, pp. 365-368) discloses a method for a non-uniform to uniform decimation for delta-sigma frequency to digital conversion (FDC). The described method combines the non-uniform to uniform conversion operation with the decimation filtering to remove the out-of-band quantization noise and to minimize frequency spreading due to the non-uniform sampling thereby reaching high precision with very low implementation complexity. Firstly, an analogous input signal is converted to a digital non-uniformly sampled output sequence $y[n]$. Applying a comb filter to the output sequence in the non-uniform domain results in a suppression of frequency spreading and quantization noise. Now, an interpolating downsampler determines desired downsampled uniform sampling times and the uniform phase estimates relating to said downsampled uniform sampling times using a known two-point interpolation method. Finally, the uniform, downsampled sequence is further processed applying a conventional low-pass and equalization filter to further suppress quantization noise and to compensate for passband droop.

CALVAGNO et al. (*"A Frequency-Domain Approach ot Interpolation from a Nonuniform Grid"*, G. Calvagno et al., Signal Processing, 52, 1996-07-0, XP004008754, Elsevier Science Publishers B.V. Amsterdam, NL, pp. 1-21) describes the comparison of several common linear interpolators for band-limited signals from nonuniformly spaced samples converting the signals to uniformly spaced samples using the concept of the by frequently transmission function. (BFTF) and thereby modelling the linear interpolation process as a linear time-varying (LTV) system. The BFTF provides a convenient means of assessing interpolator quality, because it conveys how frequency components of the input signal are mapped to the frequency axes of the output signal. Therefore, a general interpolator is defined according to equation (1), with the kernel functions Ψ*n(t)* being the inverse Fourier transform of the indicator function of the frequency support of the signal. According to each interpolator type tested, the corresponding kernel functions are calculated and possible applications of each interpolator type are compared.

OBJECT OF THE INVENTION

The object of the invention is to improve the conversion of event domain sampled input signals to time domain sampled output signal.

SUMMARY OF THE INVENTION

According to a first aspect the invention achieves the object by a digital signal processing method for digitally processing a discretized input signal provided in form of a plurality of discrete input signal values at corresponding discrete input time instants which are distributed non-eguidistantly in time according to claim 1.
According to a second aspect the invention achieves the object by a digital signal processing system for digitally processing a discretized input signal.
According to a third aspect the invention achieves the object by a computer program product including program code for carrying out a digital signal processing method, when executed on a computer system, for digitally processing a discretized input signal provided in form of a plurality of discrete input signal values at corresponding discrete input time instants which are distributed non-equidistantly in time according to claim 16.
Other features inherent in the digital signal processing method and system and the corresponding computer program product are disclosed or will become apparent to those skilled in the art from the following detailed description of embodiments and its accompanying drawings.

DESCRIPTION OF THE DRAWINGS

In the accompanying drawings,

Figs. 1a,b    show two plots of a time domain sampled signal (fig. 1a) and an event domain sampled signal (fig. 1b);
Fig. 2    shows a schematic block diagram illustrating the general method steps as well as the functional means of a preferred embodiment of the invention;
Fig. 3    depicts the Epanechnikov kernel of the linear interpolation method;
Fig. 4    schematically shows a rotational speed sensor for measuring the angular velocity of rotating axles;
Fig. 5    shows a flow diagram of the algorithm for generating of the rotational speed sensor output;
Fig. 6    schematically shows a realistic rotational speed sensor with sensor errors;
Fig. 7    depicts a plot of the rotational velocity of an ideal toothed wheel (dotted line) and of an realistic toothed wheel with sensor errors (solid line);
Fig. 8    shows the Fourier decomposition of an event domain sampled data set corresponding to the measurement of the angular velocity by a non-ideal rotational speed sensor;
Fig. 9    shows a comparison of the Fourier decompositions of a wheel speed sensor's output with and without a preferred signal preprocessing;
Fig. 10    shows a schematic diagram of the preferred signal preprocessing for removing harmonics which overlap with the signal of interest.

DESCRIPTION OF THE PREFERRED EMBODIMENTS

For a better comprehension of the invention, some of the basic terms used for its description are initially explained in more detail with relation to the sampling of a time signal. The invention is however not restricted to such sampled time signals, but may also use any other kind of signal which does not originate from a particular sampling procedure of a time continuous signal but has the same characteristics as described below.
The classical sampling technique measures the amplitude of a continuous time signal *y(t)* at regular time intervals $T_s$

$$y_k = y(kT_S) \, , \qquad k = 1,2,...,N \, . \qquad\qquad (1)$$

This series $y_k$ is herein referred to as time domain sampled signal.

In event domain sampling the continuous time signal is sampled every time the amplitude of the signal passes certain predefined signal values $y_k$

$$y(t_k) = y_k \, , \qquad k = 1,2,...,N \, . \qquad\qquad (2)$$

thus generating a series of data pairs comprising a time instant $t_k$ and a predefined signal value $y_k$. Besides, equation (2) implies problems when the continuous time signal is not monotonously increasing. However, in many practical applications the continuous time signal is monotonously increasing and the predefined signal values are further uniformly distributed, so that equation (2) can be formulated as

$$y(t_k) = kY_S \, , \qquad k = 1,2,...,N \, , \qquad\qquad (3)$$

where $Y_s$ is a constant amplitude sample period.

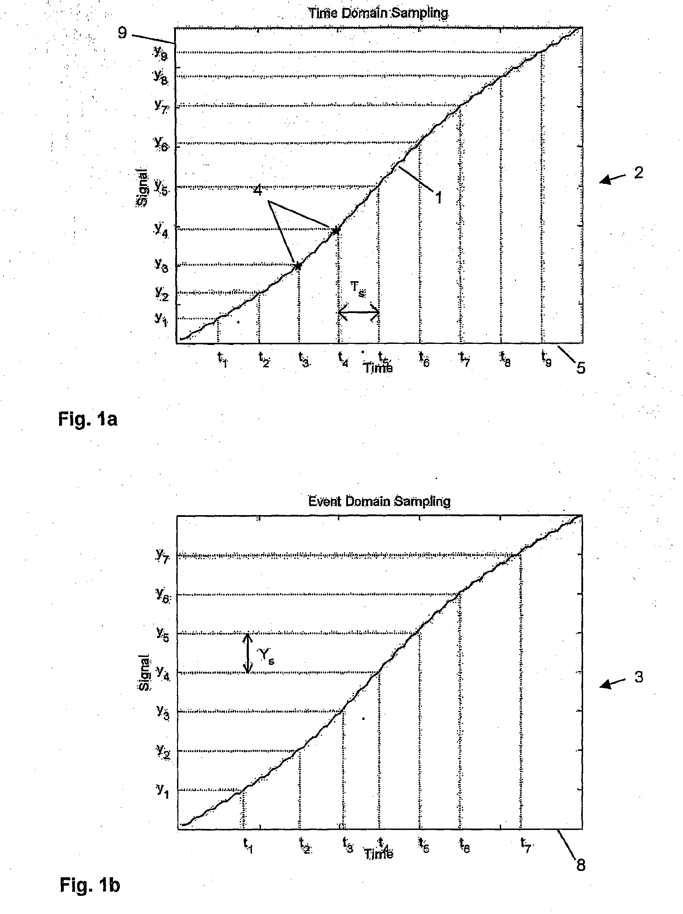

Figs. 1a,b show a continuous time signal 1 sampled in the time domain 2 and the same signal sampled in the event domain 3, respectively. In fig. 1a the time instants 4 at which measurements of the signal are performed, are equidistantly distributed over the time axes 5 with constant sample periods $T_s$. On the signal axes 9 are plotted the signal values $y_k$ according to equation (1). Fig. 1b shows the same time continuous signal, but event domain sampled whereby the predefined signal values $y_k$ are uniformly distributed with sampling period $Ys$ according to equation (3). It is clearly visible that the thus obtained time intervals are non-equidistantly distributed on the time axes 8.

The constant distance between two time instants in the time domain is called sample distance. The reciprocal of the sample distance is called sampling frequency. Half of the sample frequency is defined as the Nyquist frequency and defines the maximum frequency obtainable in the discretized time domain signal (for an introduction to Fourier decomposition of time domain to frequency domain signal see the book of S. J. Orfanidis). The maximum frequency within the discretized time domain signal is just half of the Nyquist frequency.

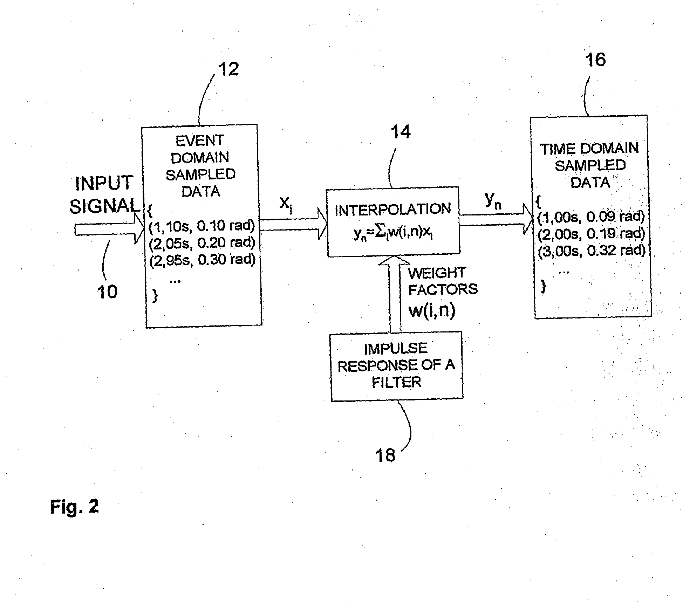

In the following, preferred embodiments of the invention will be explained in general with reference to fig. 2.

According to fig. 2 an input signal 10 is provided in form of an event domain sampled input data set 12 comprising a plurality of discrete input signal values $x_i$ at corresponding discrete input time instants which are distributed non-equidistantly in time. This input data set 12 is converted by an interpolating means 14 to a time domain output data set 16 representing the input signal 10 with discrete output signal values $y_n$ at discrete output time instants which are distributed equidistantly in time.

The input signal 10 may originate from a time continuous signal (for example a measurement signal or a control signal) whereby the term "time continuous" means that a signal value exists for every time instant, hence the signal value is a continuous function of time. When such a time continuous signal will be measured (sampled) by a measuring device, it will be provided in form of the input data set 12. Alternatively, the measurement device may directly output discrete signal values (like the wheel speed sensor described below). The input data set 12 thus may either comprise a list of value pairs of discrete signal values together with corresponding time instant values or, as in the special case of equation (3), a list of discrete time instants only.

The linear interpolation means 14 carry out a linear interpolation of the event domain sampled data 12 and output corresponding time domain sampled data set 16. It uses weight factors for the linear interpolation which are derived from an impulse response function of a filter 18.

In a preferred embodiment, the linear interpolation is carried out according to the following formula:

$$y_n = y\left(t_n^{out}\right) = y\left(nT_{int}\right) = \sum_i w(i,n)x\left(t_i^{in}\right) = \sum_i w(i,n)x_i \, . \qquad (4)$$

Here, $T_{int}$ is the sample period of the output data set 16, $x_i = x\left(t_i^{in}\right)$ denotes the input signal value at the time instant $t_i^{in}$, $y_n = y\left(t_n^{out}\right)$ denotes the output signal value at the time instant $t_n^{out} = nT_{int}$ and $w(i,n)$ denote the weight factors. The indices $i$ and $n$ denote the $i$-th element of the input data set 12 respectively the $n$-th element of the output data set 16. In general, the index $i$ of the sum runs over all elements of the input data set 12. In a specific implementation, however, the range of the index $i$ will be limited in order to reduce computational complexity. In some preferred embodiments, the weight factors are normalized according to $\sum w(i,n)=1$. This will guarantee an unbiased interpolation if $x\left(t_i^{in}\right)$ is constant.

The weight factors are chosen according to the following formula so that the linear interpolation is a convolution interpolation:

$$w_h(i,n) = h\left(nT_{int} - t_i^{in}\right)\left(t_i^{in} - t_{i-1}^{in}\right) . \tag{5}$$

Here, the function $h(t)$ is the impulse response function of a continuous time filter 18. In order to reduce the computational complexity a fixed number $M$ of normalized weights might be preferably used. The output data values are then obtained according to:

$$y(nT_{int}|t_k) = \frac{\sum_{i=k-M}^{k} w_h(i,n)x(t_i)}{\sum_{i=k-M}^{k} w_h(i,n)} = \sum_{i=k-M}^{k} w(i,n)x(t_i) . \tag{6}$$

Limiting the number of weights to $M$ has the consequence that only a fixed number of components of the discretized impulse response of the filter is used. Preferably, the underlying filter is causal, requiring that $t_k < nT_{int}$. The upper limit $k$ of the summation is preferably chosen in such that $nT_{int}-t_k$ is minimal and positive. Furthermore, $M$ shall be chosen sufficiently large, in order to adequately realize the underlying filter function. This is achieved by choosing $M$ such that

$$\left|h(nT_{int} - t_{k-m})\right| < \varepsilon, \quad \forall m > M , \tag{7}$$

is fulfilled for a given $\varepsilon$ which is chosen sufficiently small.

In summary, the above three requirements for the summation result in the following procedure. The computation of an actual output data value $y(nT_{int})$ starts with the multiplication of the input data value $x(t_k)$ at the time instant $t_k<nT_{int}$ lying nearest to the output time instant $nT_{int}$ with the corresponding weight factor $w(k,n)$ which is computed according to equation (5) (showing the relation between the discrete weight factors and the continuous impulse response function $h(t)$). Then, it is checked whether the condition ($|h(nT_{int}-t_k)|<\varepsilon$ (cp. equation (7)) is fulfilled for a given $\varepsilon$. If this condition is not fulfilled, a further multiplication corresponding to the "subsequent" index k-1 is carried out and the result is added to the result of the multiplication corresponding to the "preceding" index $k$. These steps are repeated until the above condition is fulfilled. If the condition is fulfilled, the sum of all the preceding multiplications is outputted as the output data value $y(nT_{int})$.

Furthermore, in a preferred embodiment the impulse response function of a lowpass filter having a selectable cut-off frequency is used. The advantage of such an underlying filter model is that the cut-off frequency can be chosen arbitrarily to reduce undesirable aliasing effects which may occur in classical interpolation methods as described in WO 01/87647 A1 due to the following effect. Since event domain sampled signals can contain arbitrarily high frequencies, the conversion into time domain sampled data leads to a loss of frequencies when the sampling frequency of the time domain sampled data set is too low (i.e. the sample distance is too large). Merely increasing the sampling frequency however is in practice no remedy since it increases computer memory usage and computational complexity. Furthermore, all frequencies of the event domain sampled input data set above the sampling frequency are folded in the frequency range of the output data set thus leading to a deterioration of the output data set. This effect is called aliasing. Using a lowpass filter for the interpolation as described above advantageously removes the frequencies above half of the sampling frequency and thus suppresses the aliasing, if the cut-off frequency is substantially equal to half of the desired sampling frequency.

One suitable lowpass filter is for example the second order Butterworth filter, which may be formulated as:

$$H(s) = \frac{1}{1 + a_1 \frac{s}{f_0} + a_2 \left(\frac{s}{f_0}\right)^2} \quad \text{with} \quad a_1 = \sqrt{2} \quad \text{and} \quad a_2 = 1 , \quad (8)$$

wherein $H(s)$ is the frequency function of the Butterworth filter in the frequency domain, which translates into the following impulse response in the time domain:

$$h(t) = \frac{\sqrt{2}}{f_0} e^{-\frac{f_0}{\sqrt{2}}t} \sin(\frac{f_0}{\sqrt{2}}t) , \qquad t > 0 , \qquad (9)$$

In equations (8) and (9), $f_0$ is the cut-off frequency of the Butterworth filter.
In another preferred embodiment, the weights of the linear interpolation are chosen according to an *Epanechnikov* filter kernel (i.e., impulse response function) (see also V.A. Epanechnikov, Non-parametric estimation of a multivariate probability density, Theory of Probability and Its Applications, 14:153-158, 1969), which may be formulated as:

$$w_d(t) = \frac{3}{4d} \left(1 - \frac{t^2}{d^2}\right)_+ \qquad (10)$$

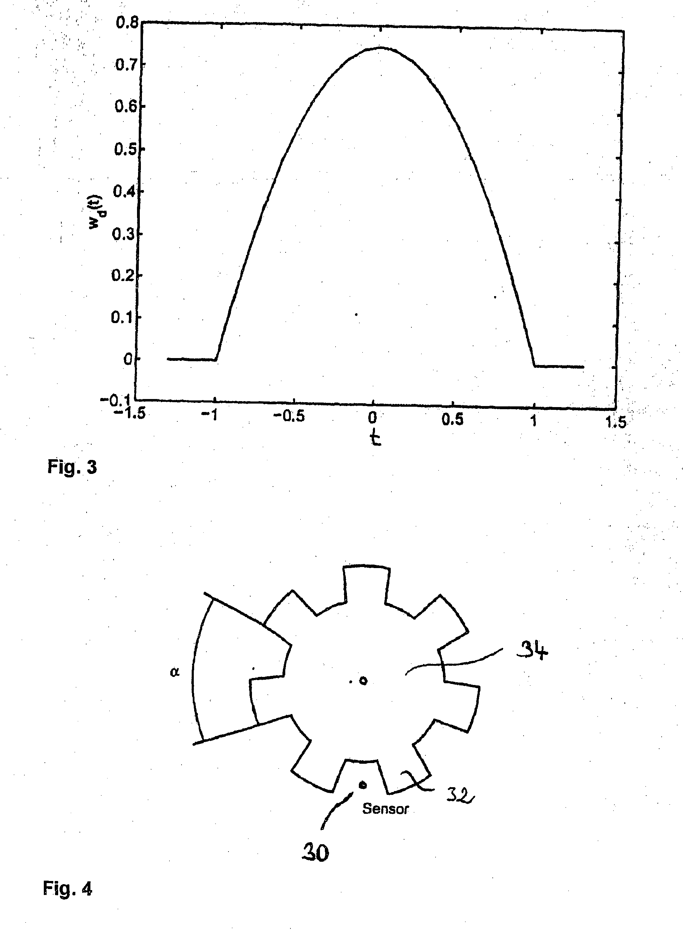

wherein $d$ denotes the size of the neighborhood (see below), and $(\cdot)_+$ denotes the positive part of the function. The Epanechnikov kernel is depicted in fig. 3 for $d = 1$. The size d of the neighborhood defines the number of weights used for the interpolation of the output signal value $y(nT_{int})$, and might be defined via the following surrounding $I_n$ of the output time instant $nT_{int}$ :

$$I_n = \left\{i \mid nT_{int} - d < t_i < nT_{int} + d\right\} \qquad (11)$$

The discretized version of the Epanechnikov kernel may be written as:

$$y(nT_{int}) = \frac{\sum_{i \in I_n} w_d(t_i - nT_{int})x(t_i)}{\sum_{i \in I_n} w_d(t_i - nT_{int})} = \sum_{i \in I_n} w(i,n)x(t_i) . \qquad (12)$$

The effect of this particular weight factor selection is a smoothing linear interpolation of the input data set attenuating or even removing large frequencies. The parameter d can be referred to as the bandwidth of the filter, and is related to the cut-off frequency of the filter. Therefore, a possible choice for the parameter d is:

$$d = T_{int} . \qquad (13)$$

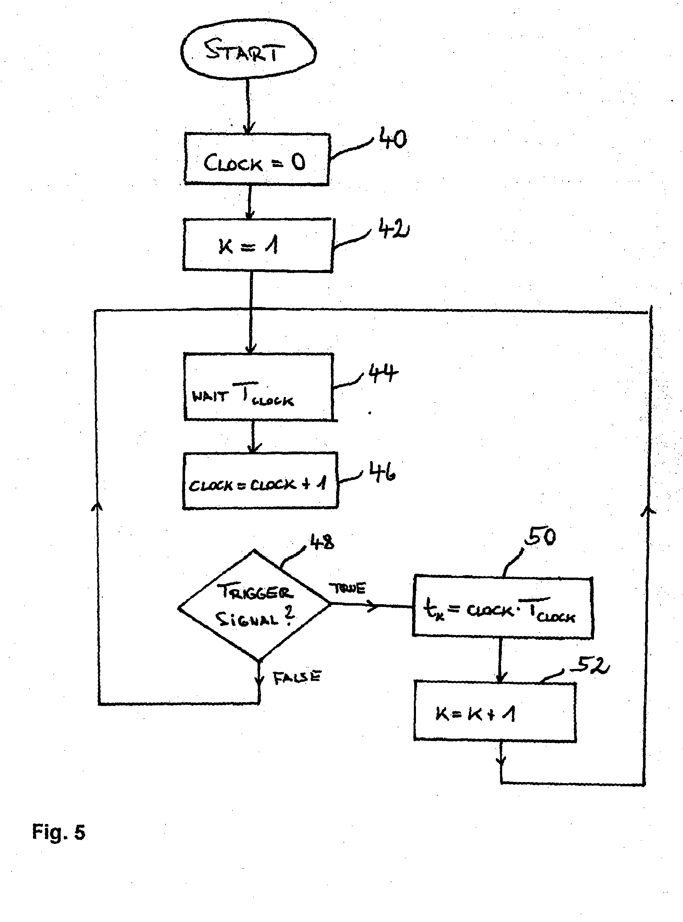

In order to reduce the computational complexity of the interpolations as described above, the weight factors of the interpolation can be pre-calculated and stored in a look-up table.
In a preferred embodiment, the event domain sampled input data set 12 which is converted to the time domain sampled output data set 16 is obtained by measuring the angular motion of a rotating axle with a rotational speed sensor which is a typical example where event domain sampling occurs. The wheel axles in vehicles, the cam shaft in engines and the motor axles in robots are some examples for the application of these sensors.
A typical example for such a rotational speed sensor is shown in Fig. 4. This sensor comprises in principal an inductive transducer 30 (for example an inductive or optical transducer, a Hall sensor, etc.,) cooperating with the teeth 32 of a toothed wheel 34. Every time a tooth 32 passes the transducer 30 it generates a trigger signal. The rotational speed is determined using the time elapsed between two adjacent trigger signals. Between two adjacent trigger signals of the transducer 30, the toothed wheel 34 rotates around the angle $\alpha=2\pi/N$, where $N$ is the number of teeth of the wheel 34. The trigger signals are sent to a microprocessor unit consisting of an internal counter with clock period $T_{clock}$ which generates the event domain sampled input data set 12 according to the algorithm depicted in Fig. 5.

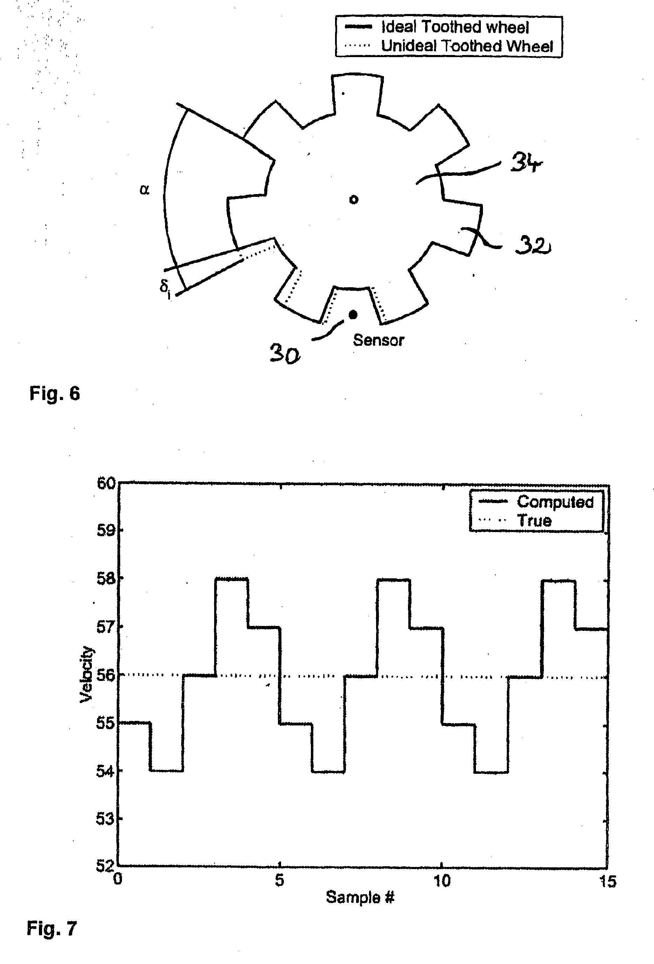

In an initialization step 40 a clock counter *clock* is initialized to the starting value *clock* = 0, and in a subsequent step 42 an event counter $k$ is initialized to the starting value $k$ = 1. After waiting until the clock period $T_{clock}$ has passed in a step 44, the clock counter *count* is incremented in step 46. Steps 44, 46 are repeated until the next trigger signal is received. When in step 48 a next trigger signal is detected, the algorithm proceeds to step 50 where the current clock value *clock* is multiplied with the timer's clock period $T_{clock}$ and the result is stored in $t_k$, the k-th input signal value of the time domain sampled input data set. The event counter $k$ is then incremented in step 52 and the algorithm returns to step 44 waiting for a next trigger signal. The time domain sampled input data set is outputted by this algorithm in the form $(t_1, t_2, t_3, ...)$ indicating the time instants at which the teeth 32 pass the transducer 30. In the following, the term rotational speed sensor refers to the rotational speed sensor device shown in fig. 5 in combination with the microprocessor unit implementing the algorithm of fig. 6.

The above rotational speed sensors realize an event domain sampling as described above which can be easily seen by replaying $Y_s$ of equation (3) by the angular distance $\alpha$. The time instants $t_k$ returned by the rotational speed sensor correspond to the angles $\alpha_k = k \cdot \alpha$ which replaces $y(t_k)$ in equation (3). In the notation of the interpolation equation (4) this is equivalent to: $t_i^{in} \cong t_k$ and $x\left(t_i^{in}\right) \cong k\alpha$ . Thus, in the time interval $[t_{k-1}, t_k]$, the rotational speed $\omega_k$ of the axle to which the sensor is attached is given by $\omega_k = \alpha / (t_k - t_{k-1})$.

In practice, the toothed wheel 34 of the rotational speed sensor is non-perfectly manufactured or may suffer wear during operation and thus shows deviations in the tooth widths and tooth distances. Fig. 6 illustrates a toothed wheel 34 wherein the outline of an ideal wheel is drawn with a dotted line and the outline of a more realistic, non-ideal wheel is drawn with a full line. The ideal tooth distance is $\alpha$ and $\delta_i$ is the offset error angle between tooth i and tooth i-1. Fig 7 shows, assuming that the wheel 34 is rotated with constant angular speed $\omega$, the angular speed measured by an ideal toothed wheel sensor, which is constant in time (dotted line), and by a real, imperfectly toothed wheel sensor, which is periodically fluctuating (solid line) with a periodicity $N$. $N$ is the number of teeth of the rotating wheel 32 ($N$ = 5 in the example of fig. 7).

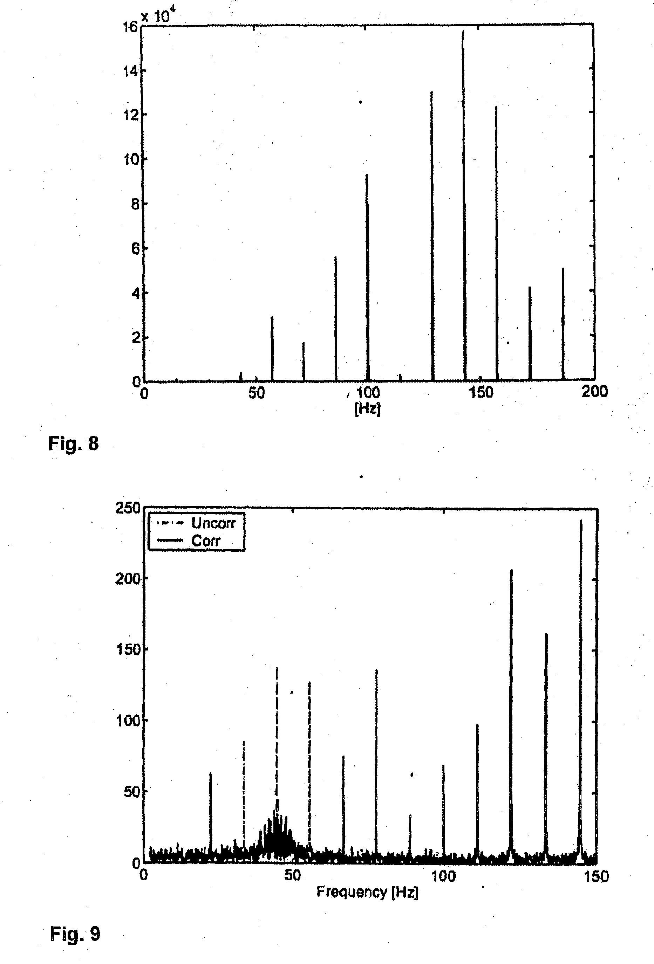

Fig. 8 shows the Fourier decomposition of the event domain sampled data set corresponding to the measurement of the angular velocity of a non-ideal rotational speed sensor. The periodic disturbance causes harmonics in the frequency domain with basic frequency equal to the revolution frequency $\omega_0/(2_\pi)$ of the wheel 34. In fig. 8, the angular velocity is equal to $\omega_0$ = *90rad/s* resulting in a basic frequency of 14.3 *Hz*. All the harmonics are multiples $f_m = m\omega_0/(2\pi)$ of the basic frequency. The harmonics may overlap with the signal of interest, and hence should preferably be removed.

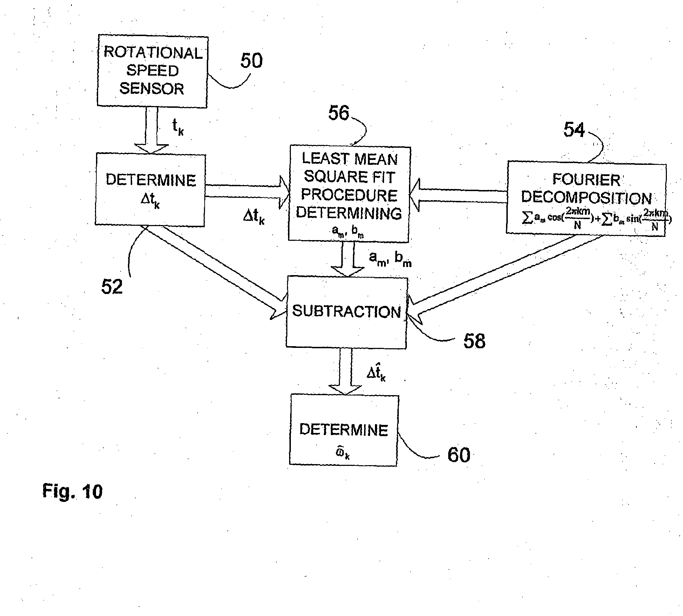

In the following, a preferred embodiment for removing the harmonics which overlap with the signal of interest is described with reference to fig. 10. These harmonics are removed in a preprocessing step before the event domain sampled data set 12 of the wheel speed sensor is converted into the time domain. If for example the signal lies in the interval [30 *Hz*, 60 *Hz*], all harmonics falling in this particular interval shall be removed. For example, if the velocity is 70 *rad/s*, the harmonics $m$ = 3, 4 and 5 should be removed.

The preprocessing adopted for rejection of the harmonics is based on computed angular velocity $\omega_k = \alpha / (t_k - t_{k-1})$ (.calculated in step 52) between two consecutive time instants $t_k$ of the event domain sampled data set which is obtained from the rotational speed sensor 50. The $\omega_k$ between two tooth passing events are influenced from the rotational speed of the axle, from the sensor errors and from vibrations of the wheel. By exploiting the periodicity of the sensor errors, the $\omega_k$ can be expanded using a Fourier series expansion (provided in step 54) expressing these sensor errors:

$$\omega_k = \widehat{\omega}_k^0 + \frac{1}{\Delta t_k} \sum_m a_m \cos(2\pi km/N) + b_m \sin(2\pi km/N) \qquad (15)$$

where $\widehat{\omega}_k^0 = 2\pi / \left(t_{k+N/2} - t_{k-N/2}\right)$ is the hypothetical angular velocity between two tooth passing events corrected for sensor errors (exploiting that $\Sigma\delta_i = 0$). The Fourier coefficients $a_m$ and $b_m$ correspond to the harmonics $f_m$. In order to estimate the Fourier coefficients $a_m$ and $b_m$ a fitting procedure, preferably a Least Mean Squares method 56 may be used. With the estimated values $\hat{a}_m$ and $\hat{b}_m$ it is then possible to subtract in step 58 the periodic sensor errors from the signal $\omega_k$:

$$\hat{\omega}_k = \omega_k - \sum_m \hat{a}_m \cos(2\pi km / N) + \hat{b}_m \sin(2\pi km / N) \ . \tag{16}$$

In order to reduce the computational effort, it is possible to restrict the preprocessing to the Fourier coefficients m of interest, e.g. the harmonics which overlap with the signal of interest. This is achieved by restricting the sum in equations (15) and (16) to the values *m* of interest.

Fig. 9 compares the Fourier decomposition of a wheel speed sensor's output in the frequency range from 0 *Hz* to 150 *Hz* with and without the above preprocessing. The dotted line represents the original signal calculated from the measured values $\omega_k$. The solid line represents $\hat{\omega}_k$, the sensor error corrected signal with suppression of the sensor error induced harmonics m = 3, 4 and 5. As can be easily seen from this comparison, only the specified frequencies for these harmonics are removed from the signal. Naturally, the particular preprocessing of sensor signals may be applied irrespective of the subsequent specific interpolation as described above.

Preferably, the above described method for converting event domain sampled data sets into time domain sampled data sets is applied to signals provided by rotational speed sensors attached to an automobile wheel axle which measure the angular velocities of a tire. The tire velocity information is used for a determination of the automobile's tire pressures. This is accomplished by analyzing the vibration modes in the tire's rotational velocity. In general, the tire can be modeled by a damped spring with a resonance frequency. The resonance frequency of a tire typically depends on the tire's air pressure. This allows the tire pressure determination by measuring vibration resonances in the tire's rotational velocity.

Wheel speed sensors as described above are used for example in anti-lock braking systems (ABS) which provide a tire-road slip control and are a frequently integrated safety feature of an automobile. Thus, the rotational wheel speed sensors of the anti-lock braking system can be used simultaneously for tire pressure monitoring and tire-road slip control.

Further details of the tire pressure determination are shown in WO 01/87647 AI.

According to an exemplified embodiment of the invention, the digital signal processing system may be any machine capable of executing a sequence of instructions that specify actions to be taken by that machine for causing the machine to perform any one of the methodologies discussed above. The machine may be an application specified integrated circuit (ASIC) including a processor and a memory unit. The instructions may reside, completely or at least partially, within the memory and/or within the processor.

In particular, the digital signal processing system may be implemented in the form of a computer system within which a sequence of instructions may be executed. The computer system may then further include a video display unit, an alphanumeric input device (e.g. a keyboard), a cursor control device (e.g. a mouse), a disk drive unit. The disk drive unit includes a machine-readable medium on which is stored the sequence of instructions (i.e., a computer program or software) embodying any one, or all, of the methodologies described above.

The computer program product may be a machine-readable medium which is capable of storing or encoding the sequence of instructions for execution by the machine and that cause the machine to perform any one of the methodologies of the present invention. The machine-readable medium shall accordingly be taken to include, but not be limited to, solid-state memories, optical and magnetic disks, and carrier wave signals.

In the above description, for simplification, it is only referred to the method case. The system case can be easily derived from the latter one by replacing at the appropriate places in the description the expression 'step' for the method case by the expression 'component' for the system case.

## Claims

1. A digital signal processing method for digitally processing a discretized input signal (12) provided in form of a plurality of discrete input signal values at corresponding discrete input time instants which are distributed non-equidistantly in time, comprising:

   converting the input signal (12) to a discretized output signal (16) corresponding to the input signal (10) with discrete output signal values at discrete output time instants which are distributed equidistantly in time, wherein the conversion is carried out by a linear interpolation (14) according to the following formula:

$$y\left(t_n^{out}\right) = \sum_i w(i,n) x\left(t_i^{in}\right) \ ,$$

$x\left(t_i^{in}\right)$ denoting the discrete input signal value at the discrete input time instant $t_i^{in}$, $y\left(t_i^{out}\right)$ denoting the discrete output signal value at the discrete output time instant $t_i^{out}$, and $w(i,n)$ denoting weight factors, **characterized in that** the weight factors ($w(i,n)$) of the linear interpolation are chosen according to the following formula:

$$w_h(i,n) = h\left(t_n^{out} - t_i^{in}\right)\left(t_i^{in} - t_{i-1}^{in}\right),$$

wherein $h$ is the impulse response function of a continuous time filter (18).

2. The method according to anyone of the preceding claims, wherein a causal filter is used as filter.

3. The method according to anyone of the preceding claims, wherein the filter is a lowpass filter having a selectable cut-off frequency.

4. The method of claim 3, wherein a Butterworth filter is used as filter.

5. The method according to claim 3 or 4, wherein the cut-off frequency is automatically selected in dependence of the sampling frequency of the output signal (16).

6. The method according to anyone of claims 1 to 5, wherein only those of the weight factors ($w(i,n)$) are used for the interpolation (14) whose corresponding value of the impulse response function is greater than a predetermined lower limit.

7. The method of claim 1, wherein the impulse response of the filter (18) is an Epanechnikov kernel.

8. The method of claim 7, wherein the Epanechnikov kernel is chosen according to the following formula:

$$w_d(t) = \frac{3}{4d}\left(1 - \frac{t^2}{d^2}\right)_+ \qquad\qquad (10)$$

wherein $d$ is a filter parameter which is chosen in dependence of the sampling frequency, and $(\cdot)_+$ denotes the positive part of the function.

9. The method of anyone of the preceding claims, wherein the input signal (10) is provided by a rotational speed sensor (30,32,34) which in particular measures the angular motion of an axle.

10. The method of claim 9, wherein the input signal (10) is preprocessed in order to remove periodical occurring sensor errors ($\delta_i$) originating from non-ideal rotational speed sensors (30,32,34), by:

fitting (56) the coefficients ($a_m,b_m$) of a Fourier series expansion (54) on the basis of the harmonics corresponding to the periodicity of the periodical occurring sensor errors ($\delta_i$) to the input signal (10);
subtracting (58) the Fourier series expansion (54) with the thus obtained coefficients ($a_m,b_m$) from the input signal (10).

11. The method of claim 9 or 10, wherein the input signal (10) corresponds to the angular motion of at least one tire of an automobile and is used for a determination of the automobile's tire pressure.

12. The method of anyone of claims 9 to 11, wherein the input signal (10) is provided by the rotational speed sensor of an anti-lock braking system of the automobile.

**13.** The method of claim 11 or 12, wherein the tire pressure is determined by a wheel vibration analysis.

**14.** The method of anyone of the preceding claims, wherein the weight factors ($w(i,n)$) of the interpolation (14) are stored in a look-up table.

**15.** A digital signal processing system for digitally processing a discretized input signal (12) provided in form of a plurality of discrete input signal values at corresponding discrete input time instants which are distributed non-equidistantly in time, comprising:

a conversion component for converting the input signal (12) to a discretized output signal (16) corresponding to the input signal (10) with discrete output signal values at discrete output time instants which are distributed equidistantly in time, wherein the conversion is carried out by a linear interpolation (14) according to the following formula:

$$y\left(t_n^{out}\right) = \sum_i w(i,n) x\left(t_i^{in}\right) ,$$

$x\left(t_i^{in}\right)$ denoting the discrete input signal value at the discrete input time instant $t_i^{in}$, $y\left(t_i^{out}\right)$ denoting the discrete output signal value at the discrete output time instant $t_i^{out}$, and $w(i,n)$ denoting weight factors, **characterized in that** the weight factors ($w(i,n)$) of the linear interpolation are chosen according to the following formula:

$$w_h\left(i,n\right) = h\left(t_n^{out} - t_i^{in}\right)\left(t_i^{in} - t_{i-1}^{in}\right) ,$$

wherein $h$ is the impulse response function of a continuous time filter (18).

**16.** A computer program product including program code for carrying out a digital signal processing method, when executed on a computer system, for digitally processing a discretized input signal (12) provided in form of a plurality of discrete input signal values at corresponding discrete input time instants which are distributed non-equidistantly in time, comprising:

converting the input signal (12) to a discretized output signal (16) corresponding to the input signal (10) with discrete output signal values at discrete output time instants which are distributed equidistantly in time, wherein the conversion is carried out by a linear interpolation (14) according to the following formula:

$$y\left(t_n^{out}\right) = \sum_i w(i,n) x\left(t_i^{in}\right) ,$$

$x\left(t_i^{in}\right)$ denoting the discrete input signal value at the discrete input time instant $t_i^{in}$, $y\left(t_i^{out}\right)$ denoting the discrete output signal value at the discrete output time instant $t_i^{out}$, and $w(i,n)$ denoting weight factors, **characterized in that** the weight factors ($w(i,n)$) of the linear interpolation are chosen according to the following formula:

$$w_h\left(i,n\right) = h\left(t_n^{out} - t_i^{in}\right)\left(t_i^{in} - t_{i-1}^{in}\right) ,$$

wherein *h* is the impulse response function of a continuous time filter (18).

**Patentansprüche**

1. Digitalsignalverarbeitungsverfahren zum digitalen Verarbeiten eines diskretisierten Eingangssignals (12), das in Form einer Vielzahl von diskreten Eingangssignalwerten zu entsprechenden diskreten Eingangszeitpunkten bereitgestellt wird, die zeitlich nicht-äquidistant verteilt sind, umfassend:

   Umwandeln des Eingangssignals (12) in ein diskretisiertes Ausgangssignal (16), das dem Eingangssignal (10) entspricht, mit diskreten Ausgangssignalwerten zu diskreten Ausgangszeitpunkten, die zeitlich äquidistant verteilt sind, wobei die Umwandlung mittels einer linearen Interpolation (14) gemäß der folgenden Formel durchgeführt wird:

$$y\left(t_n^{out}\right) = \sum_i w(i,n)x\left(t_i^{in}\right),$$

   wobei $x\left(t_i^{in}\right)$ den diskreten Eingangssignalwert zu dem diskreten Eingangszeitpunkt $t_i^{in}$ bezeichnet, $y\left(t_i^{out}\right)$ den diskreten Ausgangssignalwert zu dem diskreten Ausgangszeitpunkt $t_i^{out}$ bezeichnet, und $w(i, n)$ Gewichtungsfaktoren bezeichnen,
   **dadurch gekennzeichnet, dass** die Gewichtungsfaktoren ($w(i,n)$) der linearen Interpolation gemäß der folgenden Formel ausgewählt werden:

$$w_h\left(i,n\right) = h\left(t_n^{out} - t_i^{in}\right)\left(t_i^{in} - t_{i-1}^{in}\right),$$

   wobei *h* die Impulsantwortfunktion eines zeitkontinuierlichen Filters (18) ist.

2. Verfahren nach einem der vorhergehenden Ansprüche, wobei ein Kausalfilter als Filter verwendet wird.

3. Verfahren nach einem der vorhergehenden Ansprüche, wobei das Filter ein Tiefpassfilter mit einer wählbaren Grenzfrequenz ist.

4. Verfahren nach Anspruch 3, wobei ein Butterworth-Filter als Filter verwendet wird.

5. Verfahren nach Anspruch 3 oder 4, wobei die Grenzfrequenz automatisch in Abhängigkeit von der Abtastfrequenz des Ausgangssignals (16) ausgewählt wird.

6. Verfahren nach einem der Ansprüche 1 bis 5, wobei nur diejenigen der Gewichtungsfaktoren ($w(i,n)$) für die Interpolation (14) verwendet werden, deren entsprechender Wert der Impulsantwortfunktion größer ist als ein vorbestimmter unterer Grenzwert.

7. Verfahren nach Anspruch 1, wobei die Impulsantwort des Filters (18) ein Epanechnikov-Kernel ist.

8. Verfahren nach Anspruch 7, wobei der Epanechnikov-Kernel entsprechend der folgenden Formel gewählt wird:

$$w_d(t) = \frac{3}{4d}\left(1 - \frac{t^2}{d^2}\right)_+$$

wobei d ein Filterparameter ist, der in Abhängigkeit von der Abtastfrequenz gewählt wird, und $(\cdot)_+$ den positiven Teil der Funktion bezeichnet.

9. Verfahren nach einem der vorhergehenden Ansprüche, wobei das Eingangssignal (10) durch einen Drehzahlsensor (30,32,34) bereitgestellt wird, der insbesondere die Winkelbewegung einer Achse misst.

10. Verfahren nach Anspruch 9, wobei das Eingangssignal (10) vorverarbeitet ist, um von nicht idealen Drehzahlsensoren (30,32,34) stammende periodisch auftretende Sensorfehler ($\delta_i$) zu beheben durch:

   Anpassen (56) der Koeffizienten ($a_m, b_m$) einer Fourier-Reihenentwicklung (54) auf der Basis der Oberwellen entsprechend der Periodizität der periodisch auftretenden Sensorfehler ($\delta_i$) an das Eingangssignal (10); Subtrahieren (58) der Fourier-Reihenentwicklung (54) mit den so erhaltenen Koeffizienten ($a_m, b_m$) von dem Eingangssignal (10).

11. Verfahren nach Anspruch 9 oder 10, wobei das Eingangssignal (10) der Winkelbewegung wenigstens eines Reifens eines Kraftfahrzeugs entspricht und für eine Bestimmung des Reifendrucks des Kraftfahrzeugs verwendet wird.

12. Verfahren nach einem der Ansprüche 9 bis 11, wobei das Eingangssignal (10) durch den Drehzahlsensor eines Antiblockiersystems des Kraftfahrzeugs bereitgestellt wird.

13. Verfahren nach Anspruch 11 oder 12, wobei der Reifendruck durch eine Rad-Schwingungsanalyse bestimmt wird.

14. Verfahren nach einem der vorhergehenden Ansprüche, wobei die Gewichtungsfaktoren ($w(i,n)$) der Interpolationsschaltung (14) in einer Nachschlagetabelle gespeichert.

15. Digitalsignalverarbeitungssystem für die digitale Verarbeitung eines diskretisierten Eingangssignal (12), das in Form einer Vielzahl von diskreten Eingangssignalwerten zu entsprechenden diskreten Eingangszeitpunkten bereitgestellt wird, die zeitlich nicht-äquidistant verteilt sind, umfassend:

   eine Umwandlungskomponente zum Umwandeln des Eingangssignals (12) in ein diskretisiertes Ausgangssignal (16), das dem Eingangssignal (10) entspricht, mit diskreten Ausgangssignalwerten zu diskreten Ausgangszeitpunkten, die zeitlich äquidistant verteilt sind, wobei die Umwandlung durch eine lineare Interpolation (14) gemäß der folgenden Formel durchgeführt wird;

$$y\left(t_n^{out}\right) = \sum_i w(i,n) x\left(t_i^{in}\right) ,$$

wobei $x\left(t_i^{in}\right)$ den diskreten Eingangssignalwert zu dem diskreten Eingangszeitpunkt $t_i^{in}$ bezeichnet, $y\left(t_i^{out}\right)$ den diskreten Ausgangssignalwert zu dem diskreten Ausgangszeitpunkt $t_i^{out}$ bezeichnet, und $w(i,n)$ Gewichtungsfaktoren bezeichnen,
**dadurch gekennzeichnet, dass** die Gewichtungsfaktoren ($w(i,n)$) der linearen Interpolation gemäß der folgenden Formel gewählt werden:

$$w_h\left(i,n\right) = h\left(t_n^{out} - t_i^{in}\right)\left(t_i^{in} - t_{i-1}^{in}\right) ,$$

wobei $h$ die Impulsantwortfunktion eines zeitkontinuierlichen Filters (18) ist.

16. Computerprogrammprodukt mit Programmcode zum Ausführen eines Digitalsignalverarbeitungsverfahrens, wenn es auf einem Computersystem ausgeführt, zur digitalen Verarbeitung eines diskretisierten Eingangssignals (12), das in Form einer Vielzahl von diskreten Eingangssignalwerten zu entsprechenden diskreten Eingangszeitpunkten bereitgestellt wird, die zeitlich nicht-äquidistant verteilt sind, umfassend:

Umwandeln des Eingangssignals (12) in ein diskretisiertes Ausgangssignal (16), das dem Eingangssignal (10) entspricht, mit diskreten Ausgangssignalwerten zu diskreten Ausgangszeitpunkten, die zeitlich äquidistant verteilt sind, wobei die Umwandlung mittels einer linearen Interpolation (14) gemäß der folgenden Formel durchgeführt wird:

$$y\left(t_n^{out}\right) = \sum_i w(i,n)x\left(t_i^{in}\right) \,,$$

wobei $x\left(t_i^{in}\right)$ den diskreten Eingangssignalwert zu dem diskreten Eingangszeitpunkt $t_i^{in}$ bezeichnet, $y\left(t_i^{out}\right)$ den diskreten Ausgangssignalwert zu dem diskreten Ausgangszeitpunkt $t_i^{out}$ bezeichnet, und $w(i,n)$ Gewichtungsfaktoren bezeichnen,
**dadurch gekennzeichnet, dass** die Gewichtungsfaktoren ($w(i,n)$) der linearen Interpolation gemäß der folgenden Formel ausgewählt werden:

$$w_h\left(i,n\right) = h\left(t_n^{out} - t_i^{in}\right)\left(t_i^{in} - t_{i-1}^{in}\right) \,,$$

wobei $h$ die Impulsantwortfunktion eines zeitkontinuierlichen Filters (18) ist.

## Revendications

1. Procédé de traitement de signal-numérique pour traiter numériquement un signal d'entrée discrétisé (12) fourni sous la forme d'une pluralité de valeurs de signal d'entrée discrètes à des instants d'entrée discrets correspondants qui sont répartis de manière non équidistante dans le temps, comprenant :

   la conversion du signal d'entrée (12) en un signal de sortie discrétisé (16) correspondant au signal d'entrée (10) avec des valeurs de signal de sortie discrètes à des instants de sortie discrets qui sont répartis de manière équidistante dans le temps, dans lequel la conversion est effectuée par une interpolation linéaire (14) conformément à la formule suivante :

$$y\left(t_n^{out}\right) = \sum_i w(i,n)x\left(t_i^{in}\right) \,,$$

   $x\left(t_i^{in}\right)$ indiquant la valeur de signal d'entrée discrète à l'instant d'entrée discret $t_i^{in}$, $y\left(t_i^{out}\right)$ indiquant la valeur de signal de sortie discrète à l'instant de sortie discret $t_i^{out}$, et $w(i,n)$ indiquant des coefficients de pondération,
   **caractérisé en ce que** les coefficients de pondération ($w(i,n)$) de l'interpolation linéaire sont choisis conformément à la formule suivante :

$$w_h\left(i,n\right) = h\left(t_n^{out} - t_i^{in}\right)\left(t_i^{in} - t_{i-1}^{in}\right) \,,$$

   dans laquelle h est la fonction de réponse impulsionnelle d'un filtre temporel continu (18).

2. Procédé selon l'une quelconque des revendications précédentes, dans lequel un filtre causal est utilisé en tant que filtre.

3. Procédé selon l'une quelconque des revendications précédentes, dans lequel le filtre est un filtre passe-bas ayant une fréquence de coupure sélectionnable.

**4.** Procédé selon la revendication 3, dans lequel un filtre Butterworth est utilisé en tant que filtre.

**5.** Procédé selon la revendication 3 ou 4, dans lequel la fréquence de coupure est sélectionnée automatiquement en fonction de la fréquence d'échantillonnage du signal de sortie (16).

**6.** Procédé selon l'une quelconque des revendications 1 à 5, dans lequel seuls les coefficients de pondération ($w(i,n)$) dont la valeur correspondante de la fonction de réponse impulsionnelle est supérieure à une limite inférieure prédéterminée sont utilisés pour l'interpolation (14).

**7.** Procédé selon la revendication 1, dans lequel la réponse impulsionnelle du filtre (18) est un noyau d'Epanechnikov.

**8.** Procédé selon la revendication 7, dans lequel le noyau d'Epanechnikov est choisi conformément à la formule suivante :

$$w_d(t) = \frac{3}{4d}\left(1 - \frac{t^2}{d^2}\right)_+ \qquad (10)$$

dans laquelle d est un paramètre de filtre qui est choisi en fonction de la fréquence d'échantillonnage, et (.)+ indique la partie positive de la fonction.

**9.** Procédé selon l'une quelconque des revendications précédentes, dans lequel le signal d'entrée (10) est fourni par un capteur de vitesse de rotation (30, 32, 34) qui, en particulier, mesure le mouvement angulaire d'un essieu.

**10.** Procédé selon la revendication 9, dans lequel le signal d'entrée (10) est traité au préalable afin de retirer les erreurs de capteurs apparaissant périodiquement ($\delta_i$) provenant de capteurs de vitesse de rotation (30, 32, 34) non idéaux, en :

ajustant (56) les coefficients ($a_m, b_m$) d'un développement en série de Fourier (54) sur la base des harmoniques correspondants à la périodicité des erreurs de capteurs apparaissant périodiquement ($\delta_i$) au signal d'entrée (10) ; soustrayant (58) le développement en série de Fourier (54) avec les coefficients ($a_m, b_m$) ainsi obtenus du signal d'entrée (10).

**11.** Procédé selon la revendication 9 ou 10, dans lequel le signal d'entrée (10) correspond au mouvement angulaire d'au moins un pneumatique d'une automobile et est utilisé pour une détermination de la pression de pneumatique de l'automobile.

**12.** Procédé selon l'une quelconque des revendications 9 à 11, dans lequel le signal d'entrée (10) est fourni par le capteur de vitesse de rotation d'un système de freinage antiblocage de l'automobile.

**13.** Procédé selon la revendication 11 ou 12, dans lequel la pression de pneumatique est déterminée par une analyse de vibration de roue.

**14.** Procédé selon l'une quelconque des revendications précédentes, dans lequel les coefficients de pondération ($w(i,n)$) de l'interpolation (14) sont mémorisés dans une table de correspondance.

**15.** Système de traitement de signal numérique pour traiter numériquement un signal d'entrée discrétisé (12) fourni sous la forme d'une pluralité de valeurs de signal d'entrée discrètes à des instants d'entrée discrets correspondants qui sont répartis de manière non équidistante dans le temps, comprenant :

un composant de conversion pour convertir le signal d'entrée (12) en un signal de sortie discrétisé (16) correspondant au signal d'entrée (10) avec des valeurs de signal de sortie discrètes à des instants de sortie discrets qui sont répartis de manière équidistante dans le temps, dans lequel la conversion est effectuée par une interpolation linéaire (14) conformément à la formule suivante :

$$y\!\left(t_n^{out}\right) = \sum_i w(i,n)x\!\left(t_i^{in}\right) ,$$

$x\!\left(t_i^{in}\right)$ indiquant la valeur de signal d'entrée discrète à l'instant d'entrée discret $t_i^{in}$ , $y\!\left(t_i^{out}\right)$ indiquant la valeur de signal de sortie discrète à l'instant de sortie discret $t_i^{out}$ , et $w(i,n)$ indiquant des coefficients de pondération,

**caractérisé en ce que** les coefficients de pondération ($w(i,n)$) de l'interpolation linéaire sont choisis conformément à la formule suivante :

$$w_h(i,n) = h\!\left(t_n^{out} - t_i^{in}\right)\!\left(t_i^{in} - t_{i-1}^{in}\right) ,$$

dans laquelle h est la fonction de réponse impulsionnelle d'un filtre temporel continu (18).

16. Produit-programme d'ordinateur comprenant un code de programme pour effectuer un procédé de traitement de signal numérique, lorsqu'il est exécuté sur un système informatique, pour traiter numériquement un signal d'entrée discrétisé (12) fourni sous la forme d'une pluralité de valeurs de signal d'entrée discrètes à des instants d'entrée discrets correspondants qui sont répartis de manière non équidistante dans le temps, comprenant :

la conversion du signal d'entrée (12) en un signal de sortie discrétisé (16) correspondant au signal d'entrée (10) avec des valeurs de signal de sortie discrètes à des instants de sortie discrets qui sont répartis de manière équidistante dans le temps, dans lequel la conversion est effectuée par une interpolation linéaire (14) conformément à la formule suivante :

$$y\!\left(t_n^{out}\right) = \sum_i w(i,n)x\!\left(t_i^{in}\right) ,$$

$x\!\left(t_i^{in}\right)$ indiquant la valeur de signal d'entrée discrète à l'instant d'entrée discret $t_i^{in}$ , $y\!\left(t_i^{out}\right)$ indiquant la valeur de signal de sortie discrète à l'instant de sortie discret $t_i^{out}$ , et $w(i,n)$ indiquant des coefficients de pondération,

**caractérisé en ce que** les coefficients de pondération ($w(i,n)$) de l'interpolation linéaire sont choisis conformément à la formule suivante :

$$w_h(i,n) = h\!\left(t_n^{out} - t_i^{in}\right)\!\left(t_i^{in} - t_{i-1}^{in}\right) ,$$

dans laquelle h est la fonction de réponse impulsionnelle d'un filtre temporel continu (18).

Fig. 1a

Fig. 1b

Fig. 2

**Fig. 3**

**Fig. 4**

Fig. 5

**Fig. 6**

**Fig. 7**

**Fig. 8**

**Fig. 9**

ROTATIONAL
SPEED
SENSOR

50

$t_k$

DETERMINE
$\Delta t_k$

52

$\Delta t_k$

56

LEAST MEAN
SQUARE FIT
PROCEDURE
DETERMINING
$a_m, b_m$

54

FOURIER
DECOMPOSITION
$\sum a_m \cos(\frac{2\pi km}{N}) + \sum b_m \sin(\frac{2\pi km}{N})$

$a_m, b_m$

SUBTRACTION

58

$\Delta \hat{t}_k$

DETERMINE
$\hat{\omega}_k$

60

Fig. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 0187647 A1

- US 4494214 A

### Non-patent literature cited in the description

- **S. J. ORFANIDIS.** Introduction to Signal Processing. Prentice Hall, 1995
- **HUFF et al.** Non-uniform-to-uniform decimation for Delta-Sigma Frequency-to-Digital Conversion. *Circuits and Systems,* 31 May 1998
- *ISCAS '98 Proceedings of the 1998 IEEE, International Symposium on Monterey,* 31 May 1998, 365-368
- **G. CALVAGNO et al.** A Frequency-Domain Approach ot Interpolation from a Nonuniform Grid. *Signal Processing,* July 1996, vol. 52, 1-21
- **V.A. EPANECHNIKOV.** Non-parametric estimation of a multivariate probability density. *Theory of Probability and Its Applications,* 1969, vol. 14, 153-158